# EUROPEAN PATENT SPECIFICATION

(11) **EP 1 788 626 B1**
(45) Date of publication and mention of the grant of the patent: **29.04.2009**
(21) Application number: 05025101.6
(22) Date of filing: 17.11.2005
(51) Int. Cl.: H01L 23/522

(54) **Multilayer circuit with variable inductor, and method of manufacturing it**
Mehrlagenschaltung mit variablem Induktor sowie Verfahren zu ihrer Herstellung
Circuit multi-couche ayant une inductance variable et son procédé de fabrication

(43) Date of publication of application: 23.05.2007
(73) Proprietor: Seiko Epson Corporation, Shinjuku-ku Tokyo 163-0811 (JP)
(72) Inventor: Cairo Molins, Josep Ignasi, Epson Europe El. Gmbh, Mod. C 2a Pl. 08190 Sant Cugat del Valle (ES)
(74) Representative: Carpintero Lopez, Francisco

(56) References cited:
- EP-A- 0 654 802
- US-A1- 2004 140 528
- US-A1- 2005 052 272
- PATENT ABSTRACTS OF JAPAN vol. 016, no. 263 (E-1216), 15 June 1992 (1992-06-15) -& JP 04 061256 A (MITSUBISHI ELECTRIC CORP), 27 February 1992 (1992-02-27)

## Description

### FIELD OF THE INVENTION

The invention relates to the field of variable inductors in microelectronic circuits, such as silicon based integrated circuits having a plurality of metal layers separated by dielectric layers.

### STATE OF THE ART

Variable passive devices are frequently used in electronic circuits; for example, in many analog and radio frequency (RF) circuits, there is a need to use some reactive components such as capacitors and inductors. Some examples of circuits in which such devices are used are filters, Voltage Controlled Oscillators (VCO), impedance matching networks, and others. In order to provide such circuits with the possibility of some degree of tuning, it is known to use variable capacitors and inductors, that is, capacitors and inductors the values of which can be varied to a certain extent. One very well known example of such a variable component is the so-called varicap diode, which allows a certain variability of the capacitance value by means of applying a variable continuous voltage. However, few examples of variable inductors are known in the field of integrated inductors, that is, in the field of inductors forming part of integrated circuits (IC).

However, such inductors can be very useful. For example, in wireless communication, as the number of available standards is increasing (at present, there are, for example, the GSM standard (operating around 900 MHz), WLAN (2.4 GHz and 5.23 GHz), GPS (1.5 GHz), etc.), there is an increasing interest in providing multifunction circuits, that is, circuits that can be easily adapted to different operating frequencies. For example, in order to provide wireless connectivity for different operating standards, instead of using a plurality of specific RFICs (Radio Frequency Integrated Circuits), one for each operating frequency band and each RFIC working exclusively at one of said bands, it could be possible to use one single RFIC, adapting it to a selected operating frequency band by "tuning" it, for example, by modifying the inductance of an inductor in the RFIC (for example, an inductor in an impedance matching network of the RFIC). It is clear that, at least in many cases, such a solution may be more cost-effective than the one involving the use of different building blocks (for example, RFICs), one for each frequency band.

Some examples of electronic variable inductors integrated in microelectronic circuits make use of the MEMS (micro-electromechanical system) technology. Obtaining these MEMS based variable inductors involves post-processing of the circuits obtained during the initial microelectronic process (such as a CMOS, BiCMOS or Bipolar process) in order to provide mechanical movement to static parts.

One example of this kind of variable inductors is disclosed in EP-A-1463070. Here, two inductors are provided, namely, one that comprises a shorted spiral inductor formed on a low-profile sliding dielectric sheet, and another one comprising a spiral inductor on a substrate. Varying degrees of overlap between the two inductors causes varying inductance values.

However, a problem involved with this kind of variable inductors based on MEMS involving moveable elements (like the above-mentioned dielectric sheet) is that their manufacture can be rather complex and expensive, and that it may be difficult to integrate them in integrated circuits, using standard IC processes (such as CMOS processes) for their manufacture.

Another variable inductance arrangement, that can be applicable to integrated circuits, and that does not require the use of MEMS, is disclosed in US-A-2004/0066236. Here, a first inductor constitutes an impedance element, and a control circuit is provided that includes a second inductor magnetically coupled to the first inductor. The inductance value of the first inductor can be changed by changing a control current flowing through the second inductor. However, a problem involved with this kind of arrangements is that an additional power-consuming control circuit is needed, which not only implies an extra amount of circuitry, but also additional power consumption, which can be inconvenient and even critical when it comes to the design of low power consumption integrated circuits.

Another example of a prior art variable inductor arrangement is disclosed in US-A-2004/0140528. Here, the variable inductor is provided in a multilayer circuit comprising a plurality of conductive (metal) layers separated by dielectric layers, of the type normally used in integrated circuits. Several inductors are provided in different metal layers (at least in two of the metal layers), whereby the inductors are connected in series, between two ports. Further, at least one MOSFET switch is also provided that can shunt one or more of said inductors, whereby the inductance value obtained between the two ports will selectively correspond to one of said inductors or to the series connection of more than one of said inductors, thus providing a variable inductor that can be varied according to a plurality of different inductance values.

This arrangement can easily be integrated into integrated circuits using standard IC processes (such as CMOS, etc.), but it may not be optimal when it comes to the issues of parasitic capacitance and quality factor. The stacked inductors can give rise to an additional capacitance between them, which can cause, for example, a reduction of the self-resonant frequency of the inductor, making it unsuitable for certain high frequency applications. Also, the disclosed arrangement may not be optimal in what concerns the quality factor; it may provide a rather low quality factor, especially in IC arrangements optimized for radio frequency (RF) applications. In this kind of IC arrangements comprising multi-layer devices with a plurality of metal layers, the upper metal layer is normally thicker than the other metal layers, in order to provide low Ohmic losses (which can be essential in RF applications). Now, when a multi-layer inductor arrangement is provided based on a multi-layer structure comprising several metal layers, the upper one being thicker than the other ones, the quality factor for the top inductor, embodied in the thicker metal layer, can be very good, but when it is combined with the other inductors, embodied in the lower and thinner metal layers, the total quality factor will be lower.

US-A-2005/0052272 discloses an arrangement involving a conductive coil to which a port is connected through a variable resistor.

### DESCRIPTION OF THE INVENTION

The invention relates to a device and method as defined in the independent claims.

A first aspect of the invention relates to a multilayer structure or circuit comprising a plurality of electrically conductive layers (such as metal layers) separated from each other by respective insulating or dielectric layers, wherein said multilayer circuit comprises at least one variable inductor. According to the invention, the variable inductor comprises
a conductive coil structure following a coil path in the thickest one of said conductive layers, two ports connected (or "connectable", through corresponding switches) to said coil structure, and
a switch arrangement, comprising at least two switches, for selectively connecting at least one of said ports to one of a plurality of specific positions of said coil structure along said coil path, thus providing for a corresponding selective inductance value of the variable inductor, between said two ports.

Thus, the entire inductor coil is embodied in one single layer, whereby there will be no additional capacitance due to stacked inductor coils. Further, with the arrangement of the invention, a good quality factor can be provided, as the entire inductor coil arrangement can be implemented in the most appropriate metal layer, for example, in the thickest metal layer.

That is, the coil structure can be arranged in a top conductive layer of said multilayer circuit, which can be a thicker conductive layer than each of a plurality of lower conductive layers.

At least one switch of the switch arrangement can be arranged so as to connect the at least one of said ports to one of said plurality of specific positions of said coil structure, through a conductive bridge embodied in another one of said conductive layers. For example, the coil structure can be embodied in a top conductive layer of said multilayer circuit, and said bridge can be embodied in the conductive layer next to said top conductive layer. The bridge can be connected to the coil structure by one or more vias in a dielectric layer separating the respective conductive layers. In the same way, the bridge can be connected to the output ports (which can be embodied in, for example, the same conductive layer as the coil structure) and/or to the switches, through respective vias.

Each switch arrangement can thus comprise N switches, each one of said switches being arranged between one of the ports and one of said specific positions of said coil structure, along said coil path, so as to selectively connect said port to said specific position or disconnect said port from said specific position, in accordance with an input signal applied to said switch. N is a number equal to 2 or more, for example, 4 or more.

Each switch can comprise a transistor, such as a MOSFET transistor, which can easily be implemented by CMOS processes, for example. The invention as very suitable for implementation based on CMOS construction processes.

Each switch can be arranged in a layer different from the layer comprising the coil structure, such as in a transistor layer embodied on a doped silicon layer, which thus makes the invention compatible with CMOS processes.

Each switch can thus be connected to the coil structure and to the corresponding port through at least one via through one or more dielectric layers separating the switch from the coil structure and from the port, respectively. Of course, the switches can also be implemented so as to separate different parts of the coil structure, so that one part of the coil structure can be connected to another part of the coil structure, and thus to a corresponding port, through a switch.

The conductive layers can be metal layers, such as copper or aluminium layers, or layers made up of an alloy based on copper and/or aluminium. These kinds of metal layers are frequently used in circuits obtained by CMOS processes.

Another aspect of the invention relates to an integrated circuit comprising a multilayer circuit as described above, further including further circuit components. For example, the integrated circuit can be an integrated circuit for a radio frequency application, and can comprise, for example, at least one low noise amplifier comprising an amplifier circuit; the variable inductor or inductors can thus form part of an impedance matching circuit for selectively adapting the low noise amplifier to one of at least two frequency bands.

A further aspect of the invention relates to a method of manufacturing a multilayer circuit as described above. The method comprises the steps of:
providing said at least two switches on a base structure;
building, on said base structure, a further multilayer structure comprising the plurality of electrically conductive layers separated from each other by respective dielectric layers, while embodying the conductive coil structure following a coil path in one of said conductive layers, and connecting said two ports to said coil structure, so that at least one of said ports is connectable to at least one of a plurality of specific positions of said coil structure along said coil path in said one of said conductive layers through said switch arrangement comprising said at least two switches, and through vias through at least one of said dielectric layers separating said at least one switch from the coil structure.

Thus, the method can easily be implemented using conventional CMOS processes, for example.

What has been said concerning the circuit is also applicable to the method of manufacturing it, *mutatis mutandis.*

### BRIEF DESCRIPTION OF THE DRAWINGS

To complete the description and in order to provide for a better understanding of the invention, a set of drawings is provided. Said drawings form an integral part of the description and illustrate some preferred embodiments of the invention, which should not be interpreted as restricting the scope of the invention, but just as an example of how the invention can be embodied. The drawings comprise the following figures:
Figure 1: a schematic top view of an arrangement in accordance with an embodiment of the invention.
Figure 2: a schematic cross section view of the arrangement shown in figure 1, along the dotted line indicated in figure 1.
Figure 3: a schematic top view of an arrangement in accordance with another embodiment of the invention.
Figure 4: a schematic perspective view of the coil structure and bridges in accordance with another embodiment of the invention.
Figure 5: a schematic cross section view of the layered structure in accordance with a possible embodiment of the invention, showing the relation between the inductor arrangement and the conductive layers.
Figure 6: a schematic circuit diagram of a low noise amplifier for an RF application, in accordance with an embodiment of the invention.
Figures 7A-7D: schematic circuit diagrams, with and without the variable inductors of the invention.
Figures 8A and 8B schematically illustrate the behaviour of a Low Noise Amplifier (LNA) implemented using variable inductors in accordance with the invention.

### DESCRIPTION OF A PREFERRED EMBODIMENT OF THE INVENTION

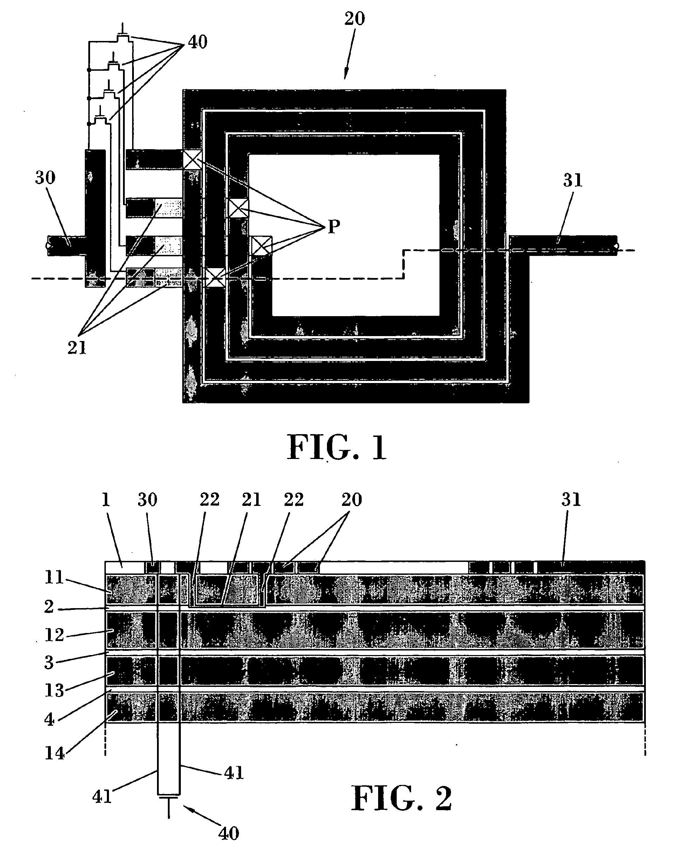

Figures 1 and 2 schematically illustrate a possible embodiment of the invention, wherein the multilayer circuit comprises a plurality of metal layers (1, 2, 3, 4) (for example, copper and/or aluminium layers) separated by dielectric layers (11, 12, 13, 14) of silicon dioxide. A coil structure (20) is provided in the top metal layer 1, which is the thickest metal layer, as usual in CMOS circuits for many applications. Further, there are two ports (30, 31) to which the coil structure is connected. One of said ports (31) is connected to a fixed position of the coil structure (namely, to one end of the coil), whereas the other port (30) is connected to the coil structure through a switch arrangement comprising a plurality of MOSFET transistor switches (40), arranged so as to selectively connect the port to one of a plurality of specific positions (P) of the coil arrangement. Thus, depending on which one of said switches is in the closed state, the effective length of the coil structure between the two ports (30, 31) will vary, whereby the inductance between the two ports can be set to specific values by means of controlling the switches (40), so that a selected one of the switches is closed, whereas the other switches are open. Connection between the port (30) and the coil structure (20) takes place through a bridge (21) in the metal layer (2) immediately below the top metal layer (1), to which the bridge is connected by respective vias (22). Further, as shown schematically in figures 1 and 2, the connection takes places through the respective switch (40), which is implemented in a transistor layer below the metal layers, and through the corresponding vias (41) passing through the plurality of dielectric layers (11, 12, 13, 14) separating the first metal layer (1) and the transistor layer.

In the embodiment illustrated in figure 1, there are four switches, whereby the inductor can be selectively set to four different values, in accordance with the input instructions delivered to the switches, setting their states to open and closed, respectively.

In the following table, examples of different inductance values obtainable with this kind of circuit, as well as the corresponding quality factors, are shown.

| **Number of turns** | **Inductance (nH)** | | **Quality Factor** | |
|---|---|---|---|---|
| | *2.5 GHz* | *5 GHz* | *2.5 GHz* | *5 GHz* |
| 1 | 3.74 | 9.9 | 4.31 | 6.3 |
| 2 | 2.54 | 9.1 | 2.80 | 8.4 |
| 3 | 1.33 | 8.8 | 1.39 | 10.7 |
| 4 | 0.55 | 9.6 | 0.55 | 13.8 |

The Inductance (nH) has been calculated as L(nH)= Im(1/Y11)/(2*pi*f) and the quality factor, Q=Im(Y11)/Re(Y11), where Y is the admittance matrix describing the inductor model (so that Y11 is the admittance that is presented at one of the two ports of the coil) and f is the frequency of the signal, in accordance with a simulation of a possible embodiment of the circuit.

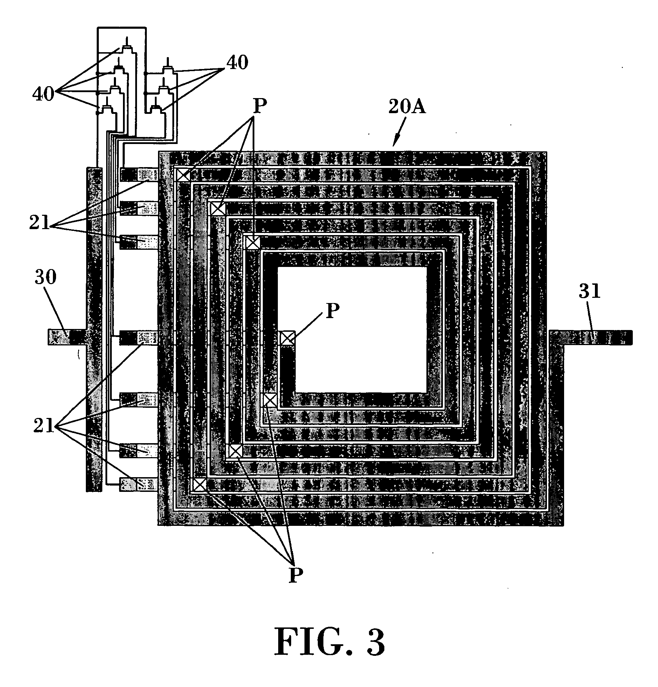

Figure 3 illustrates a similar arrangement, but with a coil structure (20A) featuring a larger number of turns, and with a larger number of switches (4), namely, seven switches, thus providing for seven different inductance values.

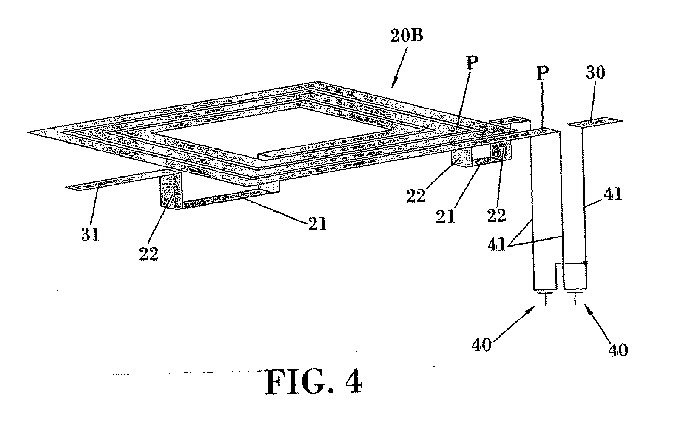

Figure 4 shows a slightly different coil structure (20B), and the way two MOSFET transistor switches (40) are provided for selectively connecting the specific positions (P) of said coil structure to the port (30). One of the specific positions is an end position that can be directly connected to the port through vias (41) and the switch (40), while another of said specific position further requires a bridge (21) in a metal layer different from the metal layer of the coil structure (20B); the bridge (21) is connected to the coil structure and to the port (30) by respective vias (22).

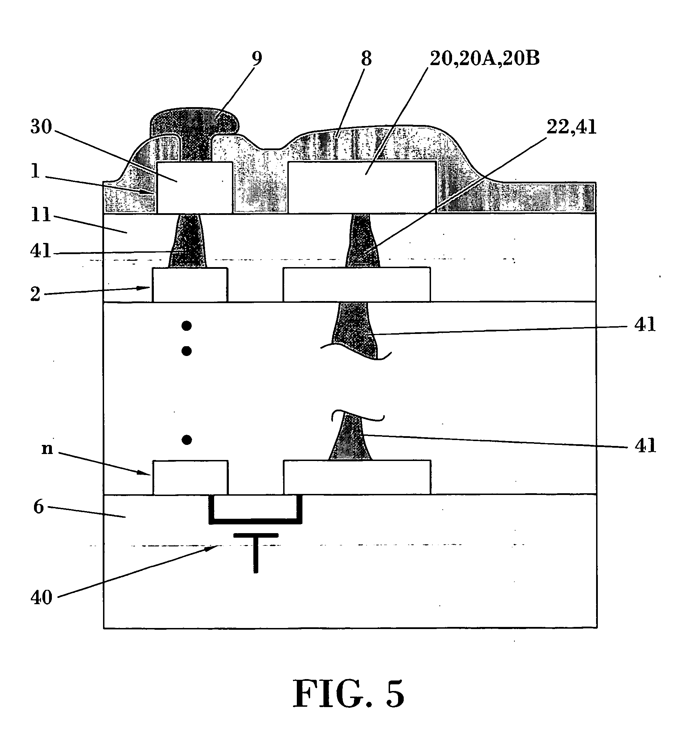

Figure 5 shows a cross section of the multilayer circuit according to a possible embodiment of the invention, based on a CMOS structure in which a p-doped silicon substrate (6) is provided, in correspondence with which a so-called transistor layer is embodied, comprising a plurality of MOSFET transistors (40), one of which is shown in figure 5 (this structure is a conventional CMOS structure), whereby each transistor comprises its corresponding source and drain, and also a gate to which the control signal for controlling the transistor switch (40) is applied (in a manner evident to the skilled person, wherefore no further discussion on this matter is needed here).

Above the silicon substrate 6 and the transistor layer there is a plurality of metal layers (1, 2, ..., n) separated by the respective dielectric layers (11, ...). As mentioned above, the transistor switches (40) are, in this embodiment, connected to the top metal layer (1) by vias (41) through the respective dielectric layers; thus, the switch (40) can connect the relevant part of the coil structure (20, 20A, 20B) to the port (30).

On top of the last metal layer there is one or more dielectric layers and/or coating layers (8) provided for protecting the circuit (in accordance with conventional CMOS circuit layout). A metallic contact (9) can be provided so as to allow a port (30) to be connected to an external circuit.

According to one embodiment of the invention, the multilayer circuit can be or include a Low Noise Amplifier (LNA) for radio frequency applications, whereby the variable inductor or inductors (100) can be used to optimize the performance of the amplifier in two different frequency bands.

LNAs are used in radio devices to capture the signal coming from the antenna and to amplify it so that it can be used by the rest of the receiver part of the radio. The signal at the antenna terminals is very weak, that is, it has a low amplitude. That means that the LNA that is used to amplify the signal (LNA) must introduce very little noise, in order to maintain a good sensibility and, thus, be able to correctly sense and amplify the low level signals received from the antenna (this is why the amplifier is called a Low Noise Amplifier). In order to interface the LNA with the antenna, a matching network is needed, that adapts the impedances between the amplifier part and the antenna part, so as to provide maximum power transfer from antenna to amplifier at the lowest possible noise level. This matching network is implemented with passive devices such as inductors and capacitors. Especially, high quality factor inductors are needed to design such matching networks, so that they do not introduce too much noise.

With the use of high quality variable inductors, such as the one described herein, it is possible to adapt the LNA to different frequency bands, thus making the device useful for operation at different frequencies. This is done by modifying the properties of the matching networks of the device, that is, the input matching network and the output matching network. These networks must be designed very carefully in order to establish an adequate compromise between power gain and noise (two basic variables to consider in connection with LNAs).

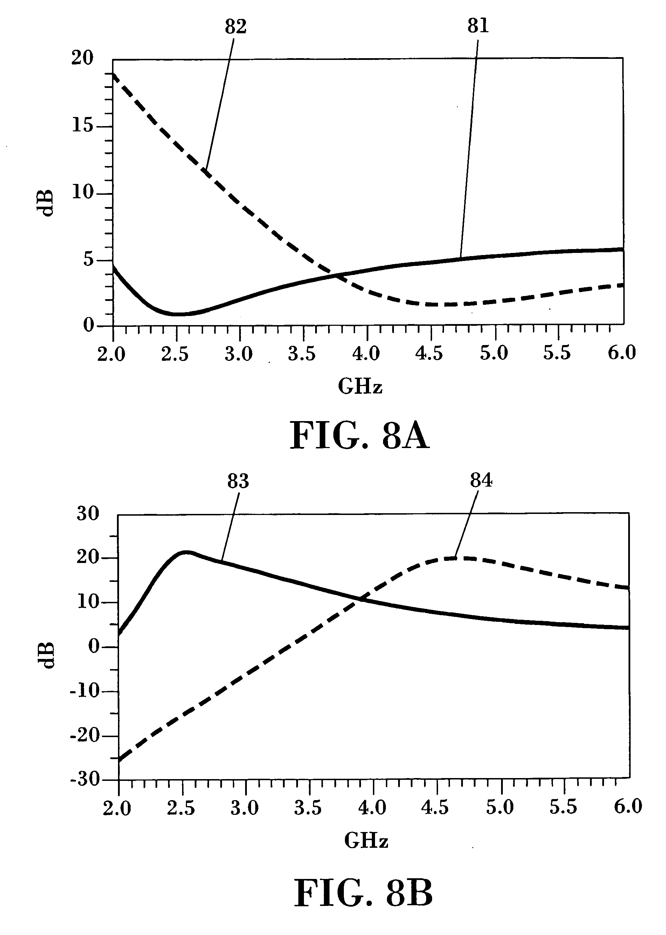

Figures 8A and 8B schematically illustrate the behaviour of an LNA implemented using a variable inductor in accordance with the invention in the input and output matching networks. In this case the design of the inductors has been made so as to optimise the performance of the LÑA at 2.4 GHz (solid line 81 in figure 8A and 83 in figure 8B) and also at 4.5 GHz (dashed line 82 in figure 8A and 84 in figure 8B). Figure 8A schematically illustrates the noise figure (nf) of the LNA in dB (decibels) (vertical axis) at the input port. The noise figure is a well known concept that describes the noise behaviour of an electric circuit, in terms of its contribution to the noise at an specific point of a circuit. It is calculated according to the IEEE (Institute of Electric and Electronic Engineering) standard with the input port at 290 K, over the frequency range (in GHz) indicated on the horizontal axis and for the 2.4 GHz mode (81) and the 4.5 GHz mode (82), respectively. Figure 8B shows a plotting of the gain of the LNA in dB (vertical axis), over the frequency range (in GHz) indicated on the horizontal axis, for the LNA operating in the 2.4 GHz mode (graph 83) and in the 4.5 GHz mode (graph 84).

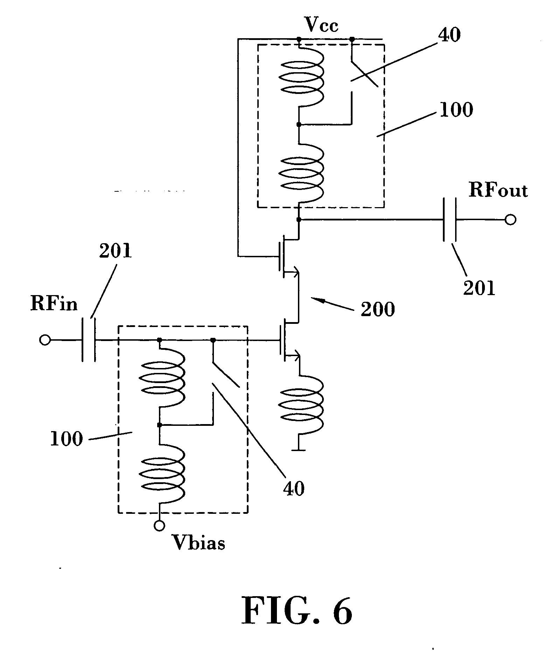

Figure 6 shows a schematic circuit diagram of a Low Noise Amplifier (200) and of its matching networks, both including a capacitor (201) and a variable inductor (100) in accordance with the present invention. A radio frequency signal (RFin) is received at the input and a radio frequency signal (RFout) is delivered to an output of the circuit, to which an operating voltage (Vcc) and a bias voltage (Vbias) are applied in a conventional manner. By controlling the state of the switches (40), the inductance value of the inductor can be changed, so as to selectively adapt the matching network to different frequency bands (one frequency band corresponding to each possible state of the switch arrangement), for example, so as to selectively adapt the device to an operating frequency of 2.4 GHz or 5 GHz, two frequencies in the ISM (Industrial Scientific and Medical) band, for which a large number of products exist in the market.

Of course, as suggested above, according to the number of switches used, the inductor can be switched between a corresponding number of inductance values, thus providing for adaptation of the device to a corresponding number of frequency bands.

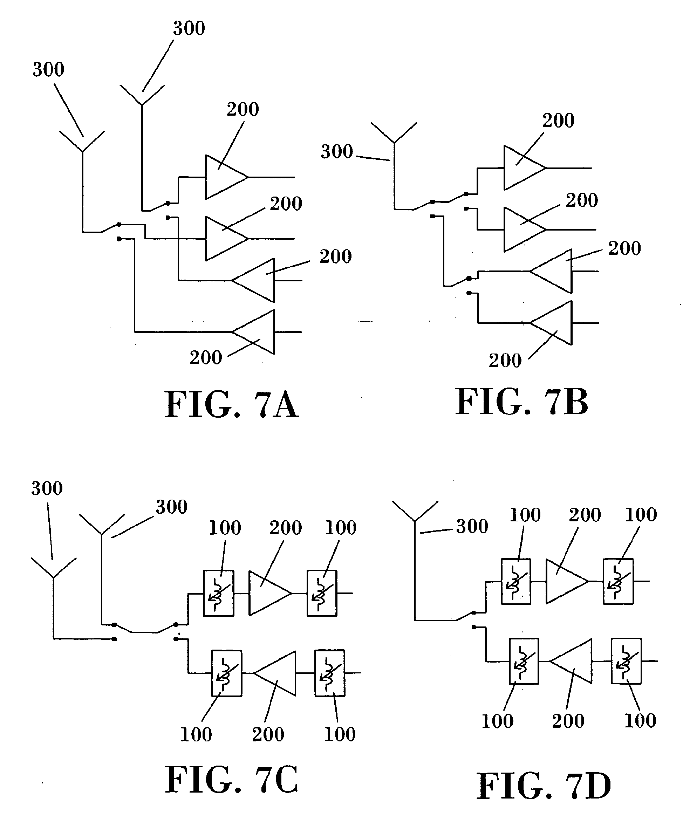

Figures 7A and 7B show examples of prior art receiver/transmitter amplifier (200) arrangements connected to antennas (300). Different amplifiers (200) are provided (each circuit includes two amplifier for the receiving part and two for the transmitting part), and switches are provided so as to use one amplifier or the other in accordance with the respective operating frequency of the device.

Figures 7C and 7D show the same types of circuits as those in 7A and 7B, respectively, but with only one amplifier for the receiving part and only one amplifier for the transmitting part. Instead, the circuit includes variable inductor (100) matching networks provided so as to adapt each amplifier to different operating frequencies.

Thus, the invention as disclosed provides a convenient way to provide variable inductances in, for example, radio frequency applications. These variable inductances can be integrated in integrated circuits based on, for example, CMOS technology.

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

## Claims

1. Multilayer circuit comprising a plurality of electrically conductive layers (1, 2, 3, 4, n) separated from each other by respective dielectric layers (11, 12, 13, 14), wherein said multilayer circuit comprises at least one variable inductor (100), wherein said variable inductor comprises
a conductive coil structure (20, 20A, 20B) following a coil path in a single one of said conductive layers,
two ports (30, 31) connected to said coil structure (20, 20A, 20B), and
a switch arrangement, **characterised in that**
the coil structure (20, 20A, 20B) is arranged in the thickest one (1) of said conductive layers;
and **in that**
the switch arrangement comprises N switches, N≥2, each one of said switches being arranged between one of the ports and one of a plurality of specific positions (P) of said coil structure, along said coil path, so as to selectively connect said port to the corresponding specific position (P) or disconnect said port from said corresponding specific position (P), in accordance with an input signal applied to said switch.

2. Multilayer circuit according to claim 1, wherein the coil structure (20, 20A, 20B) is arranged in a top conductive layer (1) of said multilayer circuit.

3. Multilayer circuit according to any of the preceding claims, wherein at least one of the switches (40) is arranged so as to connect the at least one of said ports (30) to one of said plurality of specific positions (P) of said coil structure (20, 20A, 20B), through a conductive bridge (21) embodied in another one of said conductive layers.

4. Multilayer circuit according to claim 3, wherein said bridge (21) is embodied in the conductive layer (2) next to said top conductive layer (1).

5. Multilayer circuit according to any of claims 3 and 4, wherein said bridge (21) is connected to the coil structure (20, 20A, 20B) by vias (22) in a dielectric layer (11) separating the respective conductive layers (1, 2).

6. Multilayer circuit according to any of the preceding claims, N≥4.

7. Multilayer circuit according to any of the preceding claims, wherein each switch (40) comprises a transistor.

8. Multilayer circuit according to claim 7, wherein each switch (40) comprises a MOSFET transistor.

9. Multilayer circuit according to any of the preceding claims, wherein each switch (40) is arranged in a layer different from the layer (1) comprising the coil structure.

10. Multilayer circuit according to any of the preceding claims, wherein each switch (40) is arranged in a transistor layer embodied on a doped silicon layer (6).

11. Multilayer circuit according to any of the preceding claims, wherein each switch is connected to the coil structure (20, 20A, 20B) and to the corresponding port (30) through at least one via (41) through one or more dielectric layers (11, 12, 13, 14) separating the switch (41) from the coil structure (20, 20A, 20B) and from the port (30), respectively.

12. Multilayer circuit according to any of the preceding claims, wherein said conductive layers are metal layers.

13. Multilayer circuit according to claim 12, wherein said metal layers are of copper or aluminium, or of an alloy based on copper and/or aluminium.

14. Integrated circuit comprising a multilayer circuit according to any of the preceding claims.

15. Integrated circuit for a radio frequency application, comprising a multilayer circuit according to any claims 1-13.

16. Integrated circuit according to claim 15, wherein the circuit comprises at least one low noise amplifier comprising an amplifier circuit (200), wherein the at least one variable inductor (100) forms part of an impedance matching circuit for adapting the low noise amplifier to one of at least two frequency bands.

17. Method of manufacturing a multilayer circuit comprising a plurality of electrically conductive layers (1, 2, 3, 4, n) separated from each other by respective dielectric layers (11, 12, 13, 14), wherein said multilayer circuit comprises at least one variable inductor (100) that comprises
a conductive coil structure (20, 20A, 20B) following a coil path in a single one of said conductive layers,
two ports (30, 31) connected to said coil structure (20, 20A, 20B), and
a switch arrangement for selectively connecting at least one of said ports (30) to one of a plurality of specific positions (P) of said coil structure along said coil path,
**characterised in that** the method comprises the steps of:
providing said switch arrangement, comprising at least two switches (40), on a base structure (6);
building, on said base structure, a further, multilayer, structure comprising the plurality of electrically conductive layers (1, 2, 3, 4, n) separated from each other by respective dielectric layers (11, 12, 13, 14), while embodying the conductive coil structure (20, 20A, 20B) following a coil path in a single one of said conductive layers, said one of said conductive layers being the thickest one of said conductive layers, and connecting said two ports (30, 31) to said coil structure (20, 20A, 20B), so that at least one of said ports (30) is selectively connectable to at least two of a plurality of specific positions (P) of said coil structure along said coil path in said one of said conductive layers through respective ones of said at least two switches (40) and through vias (22, 41) through at least one of said dielectric layers (1, 2, 3, 4) separating said at least two switches from the coil structure.

18. Method according to claim 17, wherein said thickest one of said conductive layers is a top conductive layer (1) of said multilayer circuit.

## Patentansprüche

1. Mehrschichtiger Schaltkreis aus einer Reihe elektrisch leitender Schichten (1, 2, 3, 4, n), die durch dielektrische Lagen (11, 12, 13, 14) voneinander getrennt sind, wobei dieser mehrschichtige Schaltkreis mindestens einen variablen Induktor (100) umfasst, welcher wiederum eine leitende Spulenstruktur (20, 20A, 20B) enthält, die in einer der genannten Schichten einen spulenförmigen Weg beschreibt, wobei der genannte Induktor außerdem zwei Anschlüsse (30, 31) umfasst, die mit der besagten Spulenstruktur (20, 20A, 20B) verbunden sind, sowie eine Schaltanordnung, die **dadurch** ausgezeichnet ist, dass die Spulenstruktur (20, 20A, 20B) in der dicksten Schicht (1) der genannten elektrisch leitenden Schichten verläuft, wobei die Schaltanordnung N Schalter umfasst, N≥2, und jeder dieser Schalter zwischen einem der Anschlüsse und einer der vielfachen spezifischen Positionen (P) der Spulenstruktur entlang dem genannten Spulenweg angeordnet ist und somit gemäß einem Eingangssignal, das dieser Schalter empfängt, den besagten Anschluss selektiv mit der jeweiligen spezifischen Position (P) verbindet oder diese Verbindung trennt.

2. Mehrschichtiger Schaltkreis gemäß Anspruch 1, wobei die Spulenstruktur (20, 20A, 20B) in einer oberen leitenden Schicht (1) dieses mehrschichtigen Schaltkreises angeordnet ist.

3. Mehrschichtiger Schaltkreis gemäß einem der vorhergehenden Ansprüche, wobei mindestens einer der Schalter (40) derart angeordnet ist, dass er mindestens einen der erwähnten Anschlüsse (30) mit einer der vielfachen spezifischen Positionen (P) der Spulenstruktur (20, 20A, 20B) über eine leitende Brücke (21) verbindet, die in einer der anderen genannten leitenden Schichten angebracht ist.

4. Mehrschichtiger Schaltkreis gemäß Anspruch 3, wobei die besagte Brücke (21) in der leitenden Schicht (2) angebracht ist, die an die obere leitende Schicht (1) grenzt.

5. Mehrschichtiger Schaltkreis gemäß Anspruch 3 oder 4, wobei die besagte Brücke (21) mit der Spulenstruktur (20, 20A, 20B) über Wege (22) verbunden ist, die in einer dielektrischen Schicht (11) verlaufen, welche die jeweiligen leitenden Schichten (1, 2) voneinander trennt.

6. Mehrschichtiger Schaltkreis gemäß einem der vorhergehenden Ansprüche mit N≥4.

7. Mehrschichtiger Schaltkreis gemäß einem der vorhergehenden Ansprüche, wobei jeder Schalter (40) einen Transistor umfasst.

8. Mehrschichtiger Schaltkreis gemäß Anspruch 7, wobei jeder Schalter (40) einen MOSFET-Transistor umfasst.

9. Mehrschichtiger Schaltkreis gemäß einem der vorhergehenden Ansprüche, wobei jeder Schalter (40) in einer Schicht angeordnet ist, die nicht mit der Schicht (1) der Spulenstruktur übereinstimmt.

10. Mehrschichtiger Schaltkreis gemäß einem der vorhergehenden Ansprüche, wobei jeder Schalter (40) in einer Transistorenschicht angeordnet ist, die auf einer dotierten Siliziumschicht (6) ausgeführt ist.

11. Mehrschichtiger Schaltkreis gemäß einem der vorhergehenden Ansprüche, wobei jeder Schalter über mindestens einen Weg (41) mit der Spulenstruktur (20, 20A, 20B) und mit dem entsprechenden Anschluss (30) verbunden ist und dieser Weg durch eine oder mehrere dielektrische Schichten (11, 12, 13, 14) verläuft, welche den Schalter (41) von der Spulenstruktur (20, 20A, 20B) und vom jeweiligen Anschluss (30) trennen.

12. Mehrschichtiger Schaltkreis gemäß einem der vorhergehenden Ansprüche, wobei die besagten leitenden Schichten Metallschichten sind.

13. Mehrschichtiger Schaltkreis gemäß einem der vorhergehenden Ansprüche, wobei die besagten Metallschichten aus Kupfer oder Aluminium oder aus einer auf Kupfer und/oder Aluminium basierenden Legierung bestehen.

14. Integrierter Schaltkreis, der einen mehrschichtigen Schaltkreis gemäß einem der vorhergehenden Ansprüche umfasst.

15. Integrierter Schaltkreis für die Verwendung bei Radiofrequenzen, welcher einen mehrschichtigen Schaltkreis gemäß einem der Ansprüche 1-13 umfasst.

16. Integrierter Schaltkreis gemäß Anspruch 15, der mindestens einen rauscharmen Verstärker mit einem Verstärkungskreis (200) umfasst, worin mindestens ein variabler Induktor (100) Teil eines Impedanzanpassungskreises bildet, um den rauscharmen Verstärker an eines der mindestens zwei Frequenzbänder anzupassen.

17. Herstellungsverfahren für einen mehrschichtigen Schaltkreis aus einer Reihe elektrisch leitender Schichten (1, 2, 3, 4, n), die durch dielektrische Lagen (11, 12, 13, 14) voneinander getrennt sind, wobei dieser mehrschichtige Schaltkreis mindestens einen variablen Induktor (100) umfasst, welcher wiederum eine leitende Spulenstruktur (20, 20A, 20B) enthält, die in einer einzigen der genannten Schichten einen spulenförmigen Weg beschreibt, wobei der genannte Induktor außerdem zwei Anschlüsse (30, 31) umfasst, die mit der besagten Spulenstruktur (20, 20A, 20B) verbunden sind, sowie eine Schaltanordnung, welche mindestens einen der besagten Anschlüsse (30) selektiv mit einer der vielfachen spezifischen Positionen (P) der Spulenstruktur (20, 20A, 20B) entlang dem genannten Spulenweg verbindet, wobei dieses Verfahren außerdem eine Reihe von Schritten umfasst; zunächst die Schaltanordnung, die aus mindestens zwei Schaltern (40) auf einer Basisstruktur (6) besteht, außerdem eine weitere, auf dieser Basis aufgebaute mehrschichtige Struktur aus einer Reihe elektrisch leitender Schichten (1, 2, 3, 4, n), die durch dielektrische Lagen (11, 12, 13, 14) voneinander getrennt sind und eine leitende Spulenstruktur (20, 20A, 20B) umfassen, die in einer einzigen der genannten Schichten einen spulenförmigen Weg beschreibt, wobei ebendiese Schicht die dickste der genannten elektrisch leitenden Schichten ist und die beiden erwähnten Anschlüsse (30, 31) derart mit der besagten Spulenstruktur (20, 20A, 20B) verbunden sind, dass sich mindestens einer der genannten Anschlüsse (30) selektiv mit mindestens zwei der vielfachen spezifischen Positionen (P) der besagten Spulenstruktur entlang dem genannten Spulenweg in einer der erwähnten leitenden Schichten verbinden lässt, wobei diese Verbindungen über je einen der besagten mindestens zwei Schalter (40) und über die Wege (22, 41) durch mindestens eine der genannten dielektrischen Schichten (1, 2, 3, 4) verlaufen, welche die mindestens zwei Schalter von der Spulenstruktur trennen.

18. Herstellungsverfahren gemäß Anspruch 17, wobei die genannte dickste Schicht unter den leitenden Schichten die obere leitende Schicht (1) des mehrschichtigen Schaltkreises ist.

## Revendications

1. Circuit multicouche comprenant une pluralité de couches électriquement conductrices (1, 2, 3, 4, n) séparées les unes des autres par des couches diélectriques respectives (11, 12, 13, 14), dans lequel ledit circuit multicouche comprend au moins un inducteur variable (100), dans lequel ledit inducteur variable comprend
une structure de bobines conductrices (20, 20A, 20B) suivant un chemin de bobine dans une seule couche desdites couches conductrices;
deux orifices (30, 31) connectés à ladite structure de bobines (20, 20A, 20B), et
une disposition de commutateurs, **caractérisé en ce que**
la structure de bobine (20, 20A, 20B) est disposée dans la couche la plus épaisse (1) desdites couches conductrices ;
et **en ce que**
la disposition de commutateurs comprend N commutateurs, N≥2, chacun desdits commutateurs étant disposé entre un des orifices et une position d'une pluralité de positions spécifiques (P) de ladite structure de bobines, le long de ledit chemin de bobine, de manière à connecter sélectivement ledit port à ladite position spécifique correspondante (P) ou déconnecter ledit port de ladite position spécifique correspondante (P), selon un signal d'entrée appliqué audit commutateur.

2. Circuit multicouche selon la revendication 1, dans lequel la structure de bobines (20, 20A, 20B) est disposée dans une couche conductrice (1) dudit circuit multicouche.

3. Circuit multicouche selon l'une quelconque des revendications précédentes, dans lequel au moins un des commutateurs (40) est disposé de manière à connecter le au moins un port desdits ports (30) à une position de ladite pluralité de positions (P) de ladite structure de bobines (20, 20A, 20B), à travers un pont conducteur (21) incorporé dans une autre couche desdites couches conductrices.

4. Circuit multicouche selon la revendication 3, dans lequel ledit pont (21) est incorporé dans la couche conductrice (2) proche de ladite couche conductrice supérieure (1)

5. Circuit multicouche selon l'une quelconque des revendications 3 et 4, dans lequel ledit pont (21) est connecté à la structure de bobines (20, 20A, 20B) par des voies (22) dans une couche diélectrique (11) séparant les couches (1,2) conductrices respectives.

6. Circuit multicouche selon l'une quelconque des revendications précédentes, N≥4.

7. Circuit multicouche selon l'une quelconque des revendications précédentes, dans lequel chaque commutateur (40) comprend un transistor.

8. Circuit multicouche selon la revendication 7, dans lequel chaque commutateur (40) comprend un transistor à effet de champ à oxydes métalliques.

9. Circuit multicouche selon l'une quelconque des revendications précédentes, dans lequel chaque commutateur (40) est disposé dans une couche différente de la couche (1) comprenant la structure de bobines.

10. Circuit multicouche selon l'une quelconque des revendications précédentes, dans lequel chaque commutateur (40) est disposé dans une couche de transistors incorporée sur une couche de silicium dopé (6).

11. Circuit multicouche selon l'une quelconque des revendications précédentes, dans lequel chaque commutateur est connecté à la structure de bobines (20, 20A, 20B) et à l'orifice (30) correspondant à travers au moins une voie (41) à travers une ou plusieurs couches diélectriques (11, 12, 13, 14) séparant le commutateur (41) de la structure de bobines (20, 20A, 20B) et de l'orifice (30), respectivement.

12. Circuit multicouche selon l'une quelconque des revendications précédentes, dans lequel lesdites couches conductrices son des couches métalliques.

13. Circuit multicouche selon la revendication 12, dans lequel lesdites couches métalliques sont en cuivre ou aluminium, ou en un alliage à base de cuivre et/ou aluminium.

14. Circuit intégré comprenant un circuit multicouche selon l'une quelconque des revendications précédentes.

15. Circuit intégré pour une application de radiofréquence comprenant un circuit multicouche selon l'une quelconque des revendications 1 - 13.

16. Circuit intégré selon la revendication 15, dans lequel le circuit comprend al moins un amplificateur à faible bruit comprenant un circuit amplificateur (200), dans lequel le au moins un inducteur variable (100) fait partie d'un circuit d'adaptation d'impédance pour adapter l'amplificateur à faible bruit à une des deux bandes de fréquences,

17. Procédé de fabrication d'un circuit multicouche comprenant une pluralité de couche électriquement conductrices (1, 2, 3, 4, n) séparées les unes des autres par des couches diélectriques (11, 12, 13, 14) respectives, dans lequel ledit circuit multicouche comprend au moins un inducteur variable (100) qui comprend
une structure de bobines conductrices (20, 20A, 20B) suivant un chemin de bobine dans une seule couche desdites couches conductrices;
deux orifices (30, 31) connectés à ladite structure de bobines (20, 20A, 20B), et
une disposition de commutateurs, **caractérisé en ce que**
la structure de bobine pour connecter sélectivement au moins un des dits orifices (30) à une position d'une pluralité de positions spécifiques (P) de ladite structure de bobines le long dudit chemin de bobine,
**caractérisé en ce que** le procédé comprend les étapes de :
fourniture de ladite disposition de commutateurs, comprenant au moins deux commutateurs (40) sur une structure de base (6) ;
construction, sur ladite structure de base, d'une autre structure multicouche comprenant la pluralité de couches électriquement conductrices (1, 2, 3, 4 n) séparées les unes des autres par des couches diélectriques (11, 12, 13, 14) respective, tout en incorporant la structure de bobines (20, 20A, 20B) conductrices suivant un chemin de bobine dans une seule couche desdites couches conductrices, ladite couche desdites couches conductrices étant la plus épaisse desdites couches conductrices, et connectant lesdits orifices (30, 31) à ladite structure de bobine (20, 20A, 20B), de manière à ce qu'au moins un desdits orifices (30) peut se connecter sélectivement à au moins deux positions d'une pluralité de positions spécifiques (P) de ladite structure de bobines le long dudit chemin de bobine dans ladite couche desdites couches conductrices à travers les commutateurs respectifs desdits au moins deux commutateurs (40) et à travers les voies (22, 41) à travers au moins une desdites couches diélectriques (1, 2, 3, 4) séparant lesdits au moins deux commutateurs de la structure de bobines.

18. Procédé selon la revendication 17, dans lequel la couche la plus épaisse desdites couches conductrices est une couche conductrice supérieure (1) dudit circuit multicouche,
